# FASCICULE DE BREVET EUROPEEN

(11) **EP 3 608 728 B1**
(45) Date de publication et mention de la délivrance du brevet: **16.02.2022**
(21) Numéro de dépôt: 18188067.5
(22) Date de dépôt: 08.08.2018
(51) Int. Cl.: G04B 17/06, G04B 17/22, G04B 45/00

(54) **SPIRAL THERMOCOMPENSÉ COLORÉ ET SON PROCÉDÉ DE FABRICATION**
THERMOKOMPENSIERTE GEFÄRBTE FEDER, UND IHR HERSTELLUNGSVERFAHREN
COLOURED THERMOCOMPENSATED SPRING AND METHOD FOR MANUFACTURING SAME

(43) Date de publication de la demande: 12.02.2020
(73) Titulaire: Nivarox-FAR S.A., 2400 Le Locle (CH)
(72) Inventeur: CUSIN, Pierre, 1423 Villars-Burquin (CH); GANDELHMAM, Alex, 2000 Neuchâtel (CH); KOSTADINOV, Anguel, 2056 Dombresson (CH)
(74) Mandataire: ICB SA

(56) Documents cités:
- WO-A1-2014/006229
- CH-A2- 709 628

## Description

### DOMAINE TECHNIQUE

La présente invention se rapporte à un ressort spiral destiné à équiper un organe régulateur d'une montre mécanique.

### ART ANTERIEUR

La valorisation d'une pièce d'horlogerie mécanique passe souvent par la mise en évidence de ses composants. A cet égard, les montres squelettes sont appréciées de la clientèle qui peut visualiser les organes et les fonctions importantes de l'objet complexe qu'elle comprend. La présentation du ressort spiral qui constitue le cœur du mouvement est particulièrement appréciée. Une attention spéciale doit dès lors être portée à l'aspect esthétique de ce composant.

La coloration est un des moyens permettant d'améliorer l'aspect esthétique d'un composant. De manière générale, les composants horlogers peuvent être colorés par diverses méthodes de déposition de couches par PVD, ALD, des procédés galvaniques, anodisation, etc. Cependant, dans le cas particulier des ressorts spiraux, le dépôt de telles couches esthétiques n'est pas compatible avec le cahier de charges de cette pièce qui doit garantir une insensibilité aux champs magnétiques ainsi qu'un comportement assurant, ensemble avec le balancier, une différence de marche minime en fonction de la température.

Le document CH709628 A2 concerne des ressorts-spiraux colorés. En particulier, des faces d'un ressort spiral colorées par effet interférentiel sont connues de ce document.

### RESUME DE L'INVENTION

La présente invention a ainsi pour objet de proposer un procédé de fabrication d'un ressort spiral permettant une mise en couleur de la surface visible du ressort spiral tout en garantissant le cahier de charges de base (raideur ajustée, amagnétique, compensations des variations thermiques de l'ensemble balancier spiral, etc.).

A cet effet, le procédé de fabrication consiste à former sur au moins une face de l'âme du ressort spiral un film mince générant une couleur sur ladite face par effet interférentiel. Le film est un film d'oxyde de silicium (SiO₂) qui contribue avec d'autres faces recouvertes d'une couche d'oxyde de silicium d'épaisseur plus importante à la compensation thermique du ressort spiral. En ajustant l'épaisseur du film, un grand choix de teintes peut être obtenu.

Plus précisément, le procédé consiste à réaliser l'opération de croissance de la couche d'oxyde de silicium en plusieurs étapes avec :
- une première étape consistant à former une première couche d'oxyde de silicium sur toutes les faces de l'âme, ladite première couche d'oxyde ayant une épaisseur égale à une fraction de l'épaisseur visée pour réaliser le ressort spiral thermocompensé,
- une seconde étape consistant à enlever sur la ou les faces de l'âme destinée à être colorée la première couche d'oxyde préalablement formée,
- une troisième étape consistant à former une deuxième couche d'oxyde de silicium sur les mêmes faces que celles de la première étape, cette deuxième couche ayant une épaisseur égale à la fraction restante de l'épaisseur visée tout en étant inférieure ou égale à 1 µm pour conférer à la ou aux faces destinées à être colorées la couleur par effet interférentiel.

Préférentiellement, la couche de compensation thermique est formée sur les faces latérales de l'âme et sur la face opposée à celle destinée à être visible au sein de la pièce d'horlogerie.

Ce procédé a pour avantage que l'élaboration de la couche colorée n'a que peu d'impact sur le procédé de fabrication du ressort spiral et sur le fonctionnement de ce dernier. Plus précisément, la formation de la couche de compensation thermique sur les faces latérales du ressort spiral rentrant le plus en ligne de compte pour le bon comportement en température n'est que peu ou pas affectée par le procédé.

D'autres caractéristiques et avantages de la présente invention apparaîtront dans la description suivante d'un mode de réalisation préféré, présenté à titre d'exemple non limitatif en référence aux dessins annexés.

### BREVE DESCRIPTION DES FIGURES

La figure 1a est une représentation en perspective d'un ressort spiral selon l'invention. La figure 1b est une section transversale d'une spire du ressort spiral de la figure 1a.
La figure 2 représente schématiquement différentes étapes du procédé selon l'invention à l'aide de vues en coupe transversale d'une spire du ressort spiral.

### DESCRIPTION DETAILLEE

La présente invention décrit un procédé de fabrication d'un composant horloger permettant une mise en couleur de la surface visible.

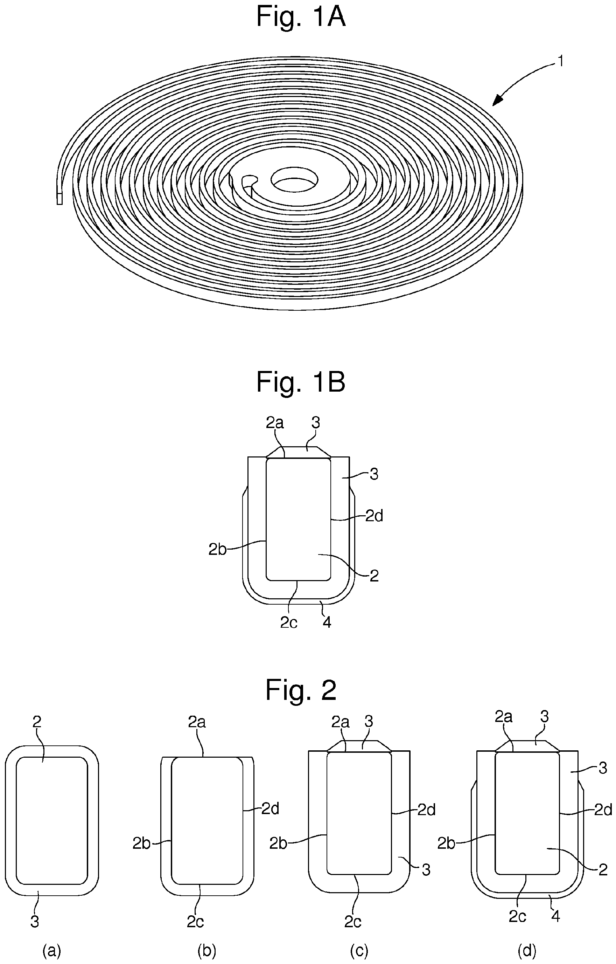

L'invention est décrite ici avec le cas simplifié et non limitatif d'un ressort spiral 1 tel que représenté aux figures 1a et 1b, et il est naturellement possible de réaliser d'autres composants selon l'invention.

L'invention décrit un ressort spiral thermocompensé ayant, à cet effet, une âme en silicium 2 monocristallin ou polycristallin recouverte avec une couche en oxyde de silicium 3 permettant d'ajuster la variation du coefficient thermoélastique du ressort spiral en fonction du comportement de l'ensemble balancier spiral (fig. 1b). Selon l'invention, au moins une face de l'âme destinée à être visible après assemblage au sein de la boîte de montre comporte une couche d'oxyde de silicium colorée par effet interférentiel, couche qu'on qualifiera de couche interférentielle. Dans l'exemple illustré, la face 2a est la face supérieure du ressort spiral destinée à être visible au travers de la glace de la boîte de montre. En variante, il pourrait s'agir de la face inférieure 2c destinée à être visible au travers du fond de la montre. Selon une autre variante, la face supérieure 2a et la face inférieure 2c pourraient comporter une couche interférentielle. La couche interférentielle se présente sous forme d'un film mince ayant une épaisseur inférieure ou égale à 1 µm qui est ajustée selon la couleur souhaitée, cette plage d'épaisseur permet d'obtenir des couleurs plus marquées (plus vives ?) et donc plus facilement visibles. A titre indicatif, la table 1 reprend en fonction de l'épaisseur du film quelques exemples de couleurs pouvant être obtenues par interférence.

**Table 1**

| **Epaisseur (Å)** | **Couleur** |
|---|---|
| 500 | Brun roux |
| 700 | Brun |
| 3100 | Bleu |
| 3900 | Jaune |
| 4700 | Violet |
| 5200 | Vert |
| 6300 | Violet-rouge |
| 8200 | Saumon |
| 9900 | Orange |

Une ou plusieurs des faces non recouvertes par le film mince sont recouvertes d'une couche de compensation thermique formée également d'oxyde de silicium. Préférentiellement, le ressort spiral comporte au moins une couche de compensation thermique sur les faces latérales 2b,2d de l'âme 2. Plus préférentiellement, l'âme comporte une couche de compensation thermique sur trois des quatre faces de sa section, à savoir dans l'exemple illustré, sur ses faces latérales 2b,2d et sa face inférieure 2c. La couche de compensation thermique se distingue de la couche interférentielle par son épaisseur qui est supérieure à celle de la couche interférentielle, et plus précisément supérieure à 1 µm. On précisera cependant que la couche interférentielle participe en partie à la compensation thermique du ressort spiral.

En outre, le ressort spiral peut comporter une couche conductrice 4 sur tout ou partie des faces comportant la couche de compensation thermique. Dans l'exemple illustré, une couche conductrice 4 continue recouvre la face inférieure 2c et en partie les faces latérales 2b,2d. La couche conductrice peut, par exemple, être réalisée avec un matériau métallique tel que l'or, le platine, le chrome, le tantale, le titane, le rhodium ou le palladium avec une épaisseur préférentiellement inférieure à 50 nm. Cette couche conductrice a une fonction antistatique et garantit une étanchéité partielle.

Le procédé mis en oeuvre pour fabriquer ce ressort spiral thermocompensé et coloré est partiellement illustré à la figure 2 à l'aide de vues en coupe d'une spire du ressort spiral. Dans cette figure, les différentes étapes mise en œuvre durant l'opération de croissance de l'oxyde de silicium sont représentées. Au préalable, le ressort spiral avec son âme en silicium peut être obtenu partant d'une plaquette en silicium (procédé wafer). De manière connue, on peut par exemple effectuer une attaque chimique par voie humide, un usinage à sec par plasma ou une gravure ionique réactive (RIE) en utilisant des masques appropriés au contour souhaité pour le spiral.

L'invention consiste à remplacer l'opération d'oxydation conventionnelle destinée à former la couche de compensation thermique par une suite de séquences comme suit. Le procédé est décrit ci-après pour une âme 2 comprenant une couche de compensation sur ses faces latérales 2b,2d et sur sa face inférieure 2c et une couche interférentielle sur sa face supérieure 2a.

Se référant à la figure 2a, une première étape consiste à faire croître sur l'âme en silicium 2 une couche d'oxyde de silicium 3 ayant une épaisseur qui est une fraction de l'épaisseur visée pour obtenir la compensation thermique. Cette étape peut, par exemple, être réalisée par oxydation thermique. Dans une deuxième étape illustrée à la figure 2b, la couche d'oxyde qui a crû sur la face supérieure 2a est retirée complètement. L'enlèvement de la couche d'oxyde peut être réalisé par gravure. La gravure est anisotrope, c.à.d. directionnelle, avec pour objet de n'affecter que la face en question. En d'autres mots, la couche 3 sur les faces latérales 2b,2d et la face inférieure 2c n'est pas impactée par la gravure. Il peut s'agir d'une gravure sèche.

Une troisième étape schématisée à la figure 2c consiste à faire croître une couche d'oxyde de silicium sur l'ensemble des faces 2a,2b,2c et 2d de manière à obtenir à la fois l'épaisseur souhaitée pour la couche interférentielle et l'épaisseur souhaitée pour obtenir la couche de compensation thermique. Cette étape peut également être réalisée par oxydation thermique.

Optionnellement dans une quatrième étape (fig.2d), la couche conductrice 4 est déposée sur la face inférieure 2c et en tout ou partie sur les faces latérales 2b et 2d. Ce dépôt peut être effectué au moyen de divers procédés connus, tels que le dépôt PVD, l'implantation ionique ou le dépôt électrolytique.

Au final, le ressort spiral présente ainsi une couche continue de SiO₂ sur toutes les faces de l'âme 2 avec une couche sur les faces latérales 2b, 2c et 2d ajustée pour la compensation thermique et une couche sur la face supérieure 2a ajustée pour obtenir la couleur souhaitée, l'épaisseur de la couche permettant la compensation thermique étant supérieure à l'épaisseur de la couche colorée.

## Revendications

1. Procédé de fabrication d'un ressort spiral (1) thermocompensé et coloré pour pièce d'horlogerie, ledit procédé comprenant les étapes successives de:
a) Mise à disposition d'un ressort spiral (1) comprenant une âme (2) en silicium ;
b) Formation d'une première couche d'oxyde de silicium (3) sur toutes les faces (2a,2b,2c,2d) de l'âme (2) du ressort spiral (1), la première couche ayant une épaisseur égale à une fraction de l'épaisseur visée pour réaliser la compensation thermique ; **caractérisé en ce qu'**il comporte aussi les étapes successives de :
c) Enlèvement sur une face (2a) de l'âme (2) destinée à être colorée par effet interférentiel, de la première couche d'oxyde de silicium (3),
d) Formation d'une deuxième couche d'oxyde de silicium (3) sur la face (2a) de l'âme (2) destinée à être colorée par effet interférentiel et sur les autres faces (2b,2c,2d) de l'âme (2) destinées à assurer la compensation thermique, la deuxième couche d'oxyde de silicium (3) ayant une épaisseur prédéterminée pour à la fois réaliser la compensation thermique et conférer à ladite face (2a) de l'âme (2)destinée à être colorée une couleur par effet interférentiel.

2. Procédé selon la revendication 1, **caractérisé en ce que** l'épaisseur de la deuxième couche d'oxyde de silicium (3) est ajustée selon la couleur souhaitée.

3. Procédé selon la revendication 1 ou 2, **caractérisé en ce que** les première et deuxième couches d'oxyde de silicium (3) sont formées par oxydation thermique aux étapes b) et d).

4. Procédé selon l'une quelconque des revendications précédentes, **caractérisé en ce que** l'étape c) est réalisée par gravure anisotrope.

5. Procédé selon l'une quelconque des revendications précédentes, **caractérisé en ce qu'**il comprend une étape e) postérieure à l'étape d) consistant à déposer une couche conductrice (4) en tout ou partie sur ladite au moins autre face (2a,2b,2c,2d) de l'âme (2) destinée à assurer la compensation thermique.

6. Procédé selon l'une quelconque des revendications précédentes, **caractérisé en ce que** les première et seconde couches d'oxyde de silicium (3) sont formées sur l'ensemble des faces (2a,2b,2c,2d) de l'âme (2), la première couche d'oxyde de silicium (3) étant enlevée à l'étape c) sur une face (2a,2c) destinée à être visible depuis l'extérieur de la pièce d'horlogerie.

7. Ressort spiral (1) thermocompensé et coloré pour pièce d'horlogerie comprenant une âme (2) en silicium, dans lequel l'âme (2) comporte :
- sur au moins une face (2a) destinée à être visible après assemblage au sein de la pièce d'horlogerie une couche interférentielle en oxyde de silicium (3), la couche interférentielle ayant une épaisseur inférieure ou égale à 1 µm conférant à ladite au moins une face (2a,2b) une couleur par effet interférentiel,
et **caractérisé en ce que** l'âme (2) comporte sur les autres faces (2b,2c,2d) une couche de compensation thermique en oxyde de silicium (3), la couche de compensation thermique ayant une épaisseur supérieure à celle de la couche interférentielle.

8. Ressort spiral (1) selon la revendication 7, **caractérisé en ce que** l'âme (2) comporte la couche interférentielle sur sa face supérieure (2a) et/ ou sa face inférieure (2c) et la couche de compensation thermique sur ses deux faces latérales (2b,2d).

9. Ressort spiral (1) selon la revendication 8, **caractérisé en ce que** l'âme (2) comporte la couche de compensation thermique sur ses deux faces latérales (2b,2d) et sur sa face supérieure (2a) ou sa face inférieure (2c).

10. Ressort spiral (1) selon l'une quelconque des revendications 7 à 9, **caractérisé en ce qu'**il comporte une couche conductrice (4) recouvrant en tout ou partie la couche de compensation thermique.

11. Pièce d'horlogerie comprenant le ressort spiral (1) selon l'une quelconque des revendications 7 à 10.

## Patentansprüche

1. Fertigungsverfahren einer thermokompensierten und gefärbten Spiralfeder (1) für einen Teil für die Uhrmacherei, wobei das Verfahren die aufeinanderfolgenden Schritte umfasst:
a) Bereitstellung einer Spiralfeder (1), umfassend, einen Kern (2) aus Silizium;
b) Bildung einer ersten Siliziumoxidschicht (3) auf allen Seiten (2a,2b,2c,2d) des Kerns (2) der Spiralfeder (1), wobei die erste Schicht eine Dicke hat, die gleich einem Bruchteil der Dicke ist, die dazu ausgelegt ist, die Temperaturkompensation zu realisieren; **dadurch gekennzeichnet, dass** es auch die aufeinanderfolgenden Schritte aufweist:
c) Entfernung der ersten Siliziumoxidschicht (3) auf einer Seite (2a) des Kerns (2), die dazu bestimmt ist, durch Interferenzeffekt gefärbt zu werden,
d) Bildung einer zweiten Siliziumoxidschicht (3) auf der Seite (2a) des Kerns (2), die dazu bestimmt ist, durch Interferenzeffekt gefärbt zu werden und auf den anderen Seiten (2b,2c,2d) des Kerns (2), die dazu bestimmt sind, die Temperaturkompensation zu gewährleisten, wobei die zweite Siliziumoxidschicht (3) eine vorbestimmte Dicke hat, um sowohl die Temperaturkompensation zu realisieren als auch der Seite (2a) des Kerns (2), die dazu bestimmt ist, gefärbt zu werden, durch Interferenzeffekt eine Farbe zu verleihen.

2. Verfahren nach Anspruch 1, **dadurch gekennzeichnet, dass** die Dicke der zweiten Siliziumoxidschicht (3) entsprechend der gewünschten Farbe angepasst wird.

3. Verfahren nach Anspruch 1 oder 2, **dadurch gekennzeichnet, dass** in den Schritten b) und d) die erste und zweite Siliziumoxidschicht (3) durch thermische Oxidation gebildet werden.

4. Verfahren nach einem der vorhergehenden Ansprüche, **dadurch gekennzeichnet, dass** der Schritt c) durch anisotropes Ätzen realisiert wird.

5. Verfahren nach einem der vorhergehenden Ansprüche, **dadurch gekennzeichnet, dass** es einen Schritt e) nach dem Schritt d) umfasst, der darin besteht, eine leitende Schicht (4) ganz oder teilweise auf der mindestens anderen Seite (2a,2b,2c,2d) des Kerns (2) aufzubringen, die dazu bestimmt ist, die Temperaturkompensation zu gewährleisten.

6. Verfahren nach einem der vorhergehenden Ansprüche, **dadurch gekennzeichnet, dass** die erste und zweite Siliziumoxidschicht (3) auf allen Seiten (2a,2b,2c,2d) des Kerns (2) gebildet sind, wobei die erste Siliziumoxidschicht (3) in Schritt c) auf einer Seite (2a,2c) entfernt wird, die dazu bestimmt ist, von außerhalb des Teils für die Uhrmacherei sichtbar zu sein.

7. Thermokompensierte und gefärbte Spiralfeder (1) für einen Teil für die Uhrmacherei, umfassend, einen Kern (2) aus Silizium, wobei der Kern (2) aufweist:
- auf mindestens einer Seite (2a), die dazu bestimmt ist, nach dem Einbau im Teil für die Uhrmacherei sichtbar zu sein, eine Interferenzschicht aus Siliziumoxid (3), wobei die Interferenzschicht eine Dicke von weniger als oder gleich 1 µm hat, was der mindestens einen Seite (2a,2b) eine Farbe durch Interferenzeffekt verleiht,
und **dadurch gekennzeichnet, dass** der Kern (2) auf den anderen Seiten (2b,2c,2d) eine Temperaturkompensationsschicht aus Siliziumoxid (3) aufweist, wobei die Temperaturkompensationsschicht eine Dicke hat, die größer ist als die der Interferenzschicht.

8. Spiralfeder (1) nach Anspruch 7, **dadurch gekennzeichnet, dass** der Kern (2) die Interferenzschicht auf seiner Oberseite (2a) und/oder seiner Unterseite (2c) aufweist und die Temperaturkompensationsschicht auf seinen beiden Seitenflächen (2b,2d).

9. Spiralfeder (1) nach Anspruch 8, **dadurch gekennzeichnet, dass** der Kern (2) die Temperaturkompensationsschicht auf seinen beiden Seitenflächen (2b,2d) aufweist und auf seiner Oberseite (2a) oder seiner Unterseite (2c).

10. Spiralfeder (1) nach einem der Ansprüche 7 bis 9, **dadurch gekennzeichnet, dass** sie eine leitende Schicht (4) aufweist, die die gesamte oder einen Teil der Temperaturkompensationsschicht bedeckt.

11. Teil für die Uhrmacherei, die Spiralfeder (1) umfassend, nach einem der Ansprüche 7 bis 10.

## Claims

1. Method for producing a thermocompensated and coloured coil spring (1) for a watchmaking piece, said method comprising the successive steps of:
a) providing a coil spring (1) comprising a silicon core (2),
b) forming a first layer of silicon oxide (3) on all of the faces (2a, 2b, 2c, 2d) of the core (2) of the coil spring (1), the first layer having a thickness which is equal to a fraction of the thickness required for achieving thermal compensation,
c) removing the first layer of silicon oxide (3) from one face (2a) of the core (2) designed to be coloured as a result of the interference effect,
d) forming a second layer of silicon oxide (3) on the face (2a) of the core (2) designed to be coloured as a result of the interference effect and on other faces (2b, 2c, 2d) of the core (2) designed to ensure thermal compensation, the second layer of silicon oxide (3) having a predetermined thickness for achieving thermal compensation and also giving to said face (2a) of the core (2) intended to be colored a colour as a result of the interference effect.

2. Method according to claim 1, **characterised in that** the thickness of the second layer of silicon oxide (3) is adjusted to the desired colour.

3. Method according to claim 1 or 2, **characterised in that** the first and second layers of silicon oxide (3) are formed by thermal oxidation in steps b) and d).

4. Method according to any of the preceding claims, **characterised in that** step c) is performed by anisotropic engraving.

5. Method according to any of the preceding claims, **characterised in that** it comprises a step e) subsequent to step d) consisting of depositing a conductive layer (4) over all or part of said at least other face (2a, 2b, 2c, 2d) of the core (2) designed to ensure thermal compensation.

6. Method according to any of the preceding claims, **characterised in that** the first and second layers of silicon oxide (3) are formed on all of the faces (2a, 2b, 2c, 2d) of the core (2), the first layer of silicon oxide (3) being removed in step c) on a face (2a, 2c) designed to be visible from the outside of the watchmaking piece.

7. Thermocompensated and coloured coil spring (1) for a watchmaking piece comprising a silicon core (2), in which the core (2) comprises:
- an interference layer of a silicon oxide (3) on at least on face (2a) designed to be visible after assembly inside the watchmaking piece, the interference layer having a thickness that is lower than or equal to 1 µm, giving said at least one face (2a, 2b) a colour as a result of the interference effect,
and **characterized in that** the core (2) comprises on the other faces (2b, 2c, 2d) a thermal compensation layer of silicon oxide (3), the thermal compensation layer having a thickness that is greater than that of the interference layer.

8. Coil spring (1) according to claim 7, **characterised in that** the core (2) comprises the interference layer on its upper face (2a) and/or its lower face (2c) and the thermal compensation layer on its two lateral faces (2b, 2d).

9. Coil spring (1) according to claim 8, **characterised in that** the core (2) comprises the thermal compensation layer on its two lateral faces (2b, 2d) and on its upper face (2a) or its lower face (2c).

10. Coil spring (1) according to any of claims 7 to 9, **characterised in that** it comprises a conductive layer (4) covering all or part of the thermal compensation layer.

11. Watchmaking piece comprising the coil spring (1) according to any of claims 7 to 10.
